# EUROPÄISCHE PATENTSCHRIFT

(11) **EP 1 265 282 B1**
(45) Veröffentlichungstag und Bekanntmachung des Hinweises auf die Patenterteilung: **25.05.2011**
(21) Anmeldenummer: 01130144.7
(22) Anmeldetag: 19.12.2001
(51) Int. Cl.: H01L 25/16, H01L 25/07, H01L 23/48

(54) **Schaltungsanordnung**
Circuit Assembly
Assemblage de circuits

(30) Priorität: 08.06.2001 DE 10127947; 22.08.2001 DE 10141114
(43) Veröffentlichungstag der Anmeldung: 11.12.2002
(73) Patentinhaber: SEMIKRON Elektronik GmbH & Co. KG, 90431 Nürnberg (DE)
(72) Erfinder: Göbl, Christian, 90441 Nürnberg (DE); Steger, Jürgen, 91355 Hilpoltstein (DE); Mourick, Paul, Dr., 90766 Fürth (DE); Beckedahl, Peter, Nashua, NH 03063 (US); Tursky, Werner, Dr., 91126 Schwabach (DE)

(56) Entgegenhaltungen:
- EP-A- 1 083 599
- DE-A1- 19 942 770
- US-A- 4 458 305
- US-A- 5 923 085

## Beschreibung

Die Erfindung betrifft eine Schaltungsanordnung mit einem Grundkörper, mit mindestens einem Substrat, das an seiner Oberseite eine Pluspol-Leiterbahn, eine Minuspol-Leiterbahn und eine Wechselstrom-Leiterbahn sowie Hilfsanschlussbahnen aufweist, mit Bauelementen, wie z.B. Transistoren, Thyristoren, Dioden, Widerstände, integrierte Schaltungen oder Sensoren, die zumindest teilweise mit diesen Leiterbahnen kontaktiert sind, mit einer Zwischenkreisplatine mit einem Pluspol- Gleichstromanschluss und einem Minuspol-Gleichstromanschluss und mit mindestens einem zwischen dem Pluspol-Gleichstromanschluss und dem Minuspol- Gleichstromanschluss eingeschalteten elektrischen Kondensator, und mit mindestens einem Wechselstromanschluss.

Eine Schaltungsanordnung mit geringen parasitären Induktivitäten mit einem elektrisch isolierenden Substrat und darauf befindlichen, gegeneinander elektrisch isolierten, metallischen Leiterbahnen und darauf angebrachten Leistungsschaltern beschreibt die ältere Patentanmeldung 100 37 533.2. Die Leistungsschalter weisen dort Leistungstransistoren auf, die vorzugsweise von MOSFETs oder von IGBTs gebildet sind.

Der Betrieb einer derartigen Schaltungsanordnung erzeugt im Zwischenkreis, auf dem Substrat sowie an den Wechselstromanschlusselementen Wärme. Die Kühlung des Zwischenkreises erfolgt nach dem Stand der Technik über Konvektion an den Bauelementen. Die Wärme des Substrates wird über den direkten Kontakt zum Kühlkörper abgeführt. Die Wärme der Wechselstromanschlusselemente wird nach dem Stand der Technik ebenfalls nur über Konvektion abgeführt. Die Erwärmung der Wechselstromanschlusselemente führt dort zu einem erhöhten Ohmschen Widerstand und damit einer geringeren Stromtragfähigkeit. Weiterhin können auf mindestens einem Wechselstromanschlusselement beispielhaft Sensoren angeordnet sein, deren Funktion durch die Erwärmung beeinträchtigt wird.

Aus der US 5,923,085 ist eine Schaltungsanordnung für ein Hybridfahrzeug bekannt. Diese weist Schaltungsteile in zwei Ebenen jeweils an den Hauptflächen eines zentral angeordneten Isolatiönskörper auf. Die Schaltungsteile bestehen aus einer Mehrzahl von in einem Rahmen angeordneter Schalteinheiten, die Mittels spezieller Verbindungselemente mit den Kondensatoren eines Zwischenkreises verbunden sind.

Der Erfindung liegt die Aufgabe zugrunde, eine Schaltungsanordnung der eingangs genannten Art mit einer geringen parasitären Induktivität zu schaffen, wobei der Herstellungs- d.h. Montageaufwand klein ist, die eine ausgezeichnete Vibrations- und Schockfestigkeit besitzt und die eine verbesserte Abführung der im Zwischenkreis und / oder an den Anschlusselementen entstehende Wärme an einen Kühlkörper gestattet.

Diese Aufgaben werden bei einer Schaltungsanordnung der eingangs genannten Art erfindungsgemäß gelöst durch mindestens eine der folgende Anordnungen:
- Die Zwischenkreisplatine weist Kontaktelemente zur direkten niederinduktiven Kontaktierung mit der Pluspol-Leiterbahn und mit der Minuspol-Leiterbahn des mindestens einen Substrates auf, der Zwischenkreisplatine und dem mindestens einen Substrat ist ein zugehöriges Wechselstromanschlusselement mit Kontaktelementen zugeordnet, und es ist eine Druckeinrichtung zur elektrischen Kontaktierung der Kontaktelemente der Zwischenkreisplatine und des mindestens einen Wechselstromanschlusselementes mit den zugehörigen Leiterbahnen des mindestens einen Substrates vorgesehen.
- Mindestens ein Anschlusszapfen zur externen elektrischen Kontaktierung wird mittels eines elektrisch isolierenden und thermisch leitenden Körpers in thermischen Kontakt mit dem Kühlkörper gebracht.
- Die internen Anschlusslaschen mindestens eines Stromanschlusses weisen Teilbereiche auf mit denen diese Anschlusslaschen über einen thermisch leitenden und elektrisch isolierenden Körper eine Verbindung mit dem Kühlkörper bilden.
- Die Zwischenkreisplatine mit mindestens einem zu kühlenden Kondensator weist Kontaktelemente zur direkten Kontaktierung mit der Pluspol-Leiterbahn und mit der Minuspol-Leiterbahn des mindestens einen Substrates auf.

Bei der erfindungsgemäßen Schaltungsanordnung sind vorzugsweise drei Substrate für die drei Drehstrom-Phasen (U, V, W) vorgesehen. Eine derartige Schaltungsanordnung weist drei Wechselstromanschlüsse auf.

Nachdem es sich bei der erfindungsgemäßen Schaltungsanordnung üblicherweise um eine Schaltungsanordnung der Leistungsklasse handelt, ist es bevorzugt, wenn der Grundkörper an einem Kühlkörper angeordnet ist, und wenn das mindestens eine Substrat mit seiner Unterseite mit dem Kühlkörper thermisch leitend kontaktiert ist. Zu diesem Zwecke kann die Unterseite des mindestens einen Substrates mit einer Metallisierung bzw. mit einer Metallschicht versehen sein, mit der das Substrat großflächig auf dem Grund- bzw. Kühlkörper aufliegt. Der Grundkörper ist rahmenförmig mit mindestens einem Abteil für ein zugehöriges Substrat ausgebildet.

Eine relativ einfache und mit geringen Herstellungskosten realisierbare Schaltungsanordnung ergibt sich, wenn erfindungsgemäß die Zwischenkreisplatine ein den Pluspol-Gleichstromanschluss aufweisendes erstes Metallflächenelement und ein den Minuspol-Gleichstromanschluss aufweisendes zweites Metallflächenelement aufweist, die voneinander elektrisch isoliert sind, wobei die Anschlusselemente des mindestens einen Kondensators der Zwischenkreisplatine mit dem jeweils zugehörigen Metallflächenelement kontaktiert und die Kontaktelemente der Zwischenkreisplatine mit dem jeweils zugehörigen Metallflächenelement des mindestens einen Substrates einstückig ausgebildet sind. Die Metallflächenelemente für den Pluspol-Gleichstromanschluss und für den Minuspol-Gleichstromanschluss können in vorteilhafter Weise von gestanzten und entsprechend gebogenen Blechen beispielsweise aus Kupfer gebildet sein. Auf diese Weise ergibt sich eine Schaltungsanordnung mit einer Zwischenkreisplatine, die einfach und preisgünstig realisierbar ist, wobei diese Vorteile mit einer kompakten und mechanisch robusten sowie niederinduktiven Ausbildung einhergehen. Die elektrische Isolierung des Metallflächenelementes des Pluspol-Gleichstromanschlusses und des Minuspol-Gleichstromanschlusses kann durch ein einfach gestaltetes Flächenelement aus elektrisch isolierendem Material realisiert sein. Zur externen elektrischen Verbindung der Gleich- und Wechselstromanschlüsse sind auf dem Grundkörper Anschlusszapfen sowie in den entsprechenden Anschlusselementen Löcher vorgesehen.

Eine andere Möglichkeit besteht beispielsweise darin, eine Zwischenkreisplatine vorzusehen, die an ihrer einen Hauptfläche einen mit dem Pluspol-Gleichstromanschluss verbundenen Metallbelag und die an ihrer gegenüberliegenden zweiten Hauptfläche einen mit dem Minuspol-Gleichstromanschluss verbundenen Metallbelag aufweist, wobei die Kontaktelemente der Zwischenkreisplatine mit Kontaktfingern ausgebildet sind, mittels welchen die Kontaktelemente mit der Zwischenkreisplatine passend kontaktiert sind. Entsprechend kann der mindestens eine Wechselstromanschluss mit Kontaktelementen versehen sein, die ebenfalls mit Kontaktfingern ausgebildet sind, um die Kontaktelemente mit dem mindestens einen Wechselstromanschlusselement zu kontaktieren. Eine solche Steckkontaktierung bedingt jedoch einen nicht zu vernachlässigenden Montageaufwand, weshalb es bevorzugt ist, die Kontaktelemente der beiden Gleichstromanschlüsse der Zwischenkreisplatine mit den entsprechenden Metallflächenelementen einstückig auszubilden und auch die Kontaktelemente des mindestens einen Wechselstromanschlusselementes mit diesem einstückig auszubilden.

Bei der erfindungsgemäßen Schaltungsanordnung hat es sich als vorteilhaft erwiesen, wenn die zur elektrischen Kontaktierung der Anschlusselemente der Zwischenkreisplatine und des mindestens einen Wechselstromanschlusselementes mit den zugehörigen Leiterbahnen des mindestens einen Substrates mittels einer Druckeinrichtung erfolgt, die einen formstabilen Druckkörper und ein begrenzt nachgiebiges Druckelement mit an den Druckkörper angepassten Flächenabmessungen aufweist. Zwischen dem formstabilen Druckkörper, der vorzugsweise aus einem Metall besteht, und dem begrenzt nachgiebigen Druckelement ist zweckmäßigerweise ein Zwischenkörper aus elektrisch isolierendem Material vorgesehen, der sich mit röhrchenartigen urchgangselementen durch den formstabilen Druckkörper erstreckt. Auf der Druckeinrichtung der erfindungsgemäßen Schaltungsanordnung kann eine Treiberschaltung angeordnet sein, wobei sich durch die Druckeinrichtung Kontaktdrahtelemente hindurcherstrecken, die mit den jeweils zugehörigen Leiterbahnen und Hilfsanschlussbahnen des mindestens einen Substrates druckkontaktiert sind.

Weitere Einzelheiten, Merkmale und Vorteile ergeben sich aus der nachfolgenden Beschreibung eines in der Zeichnung dargestellten Ausführungsbeispieles der erfindungsgemäßen Schaltungsanordnung. Es zeigen:
Figur 1 eine räumliche Darstellung wesentlicher Teile der Schaltungsanordnung, wobei der Grundkörper drei Substrate für die drei Drehstrom-Phasen aufweist, und wobei die Zwischenkreisplatine vom, mit den Substraten bestückten, rahmenartigen Grundkörper beabstandet gezeichnet ist.
Figur 2 zeigt eine räumliche Darstellung eines Substrates der Schaltungsanordnung gemäß Figur 1.
Figur 3 zeigt eine räumliche Explosionsdarstellung der Zwischenkreisplatine der Schaltungsanordnung gemäß Figur 1.
Figur 4 zeigt eine räumliche Darstellung eines Wechselstromanschlusselementes der Schaltungsanordnung gemäß Figur 1.
Figur 5 zeigt eine räumliche Explosionsdarstellung der Druckeinrichtung der Schaltungsanordnung, die in Figur 1 ohne die Druckeinrichtung zeichnerisch dargestellt ist.
Figur 6 zeigt eine räumliche Darstellung eines Teiles der Schaltungsanordnung mit einer erfinderischen Ausgestaltung eines Stromanschlusselements sowie die erfinderische Ausgestaltung eines Anschlusszapfens.
Figur 7 zeigt in einer räumlichen Darstellung einen Teil des Grundkörper sowie die erfinderisch Ausgestaltung eines Anschlusszapfens.

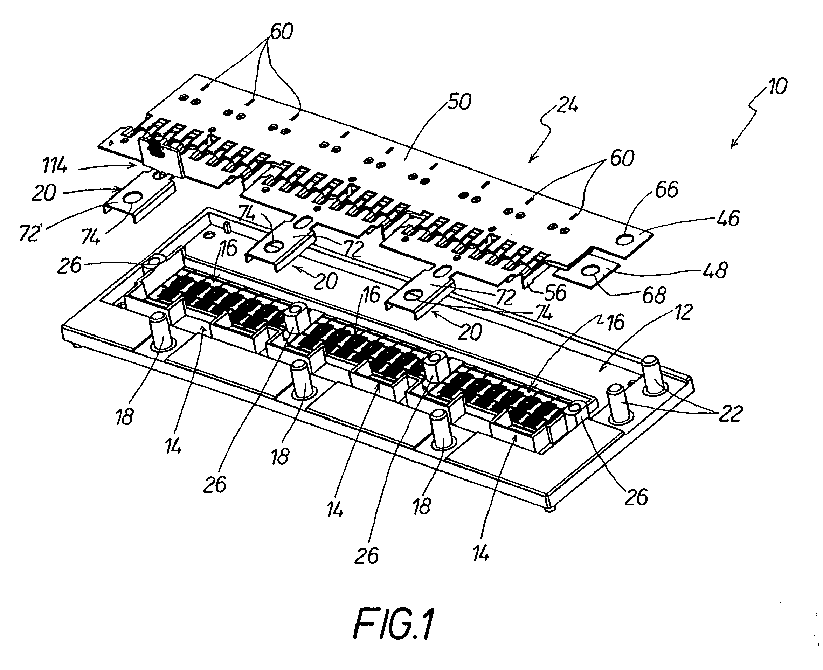

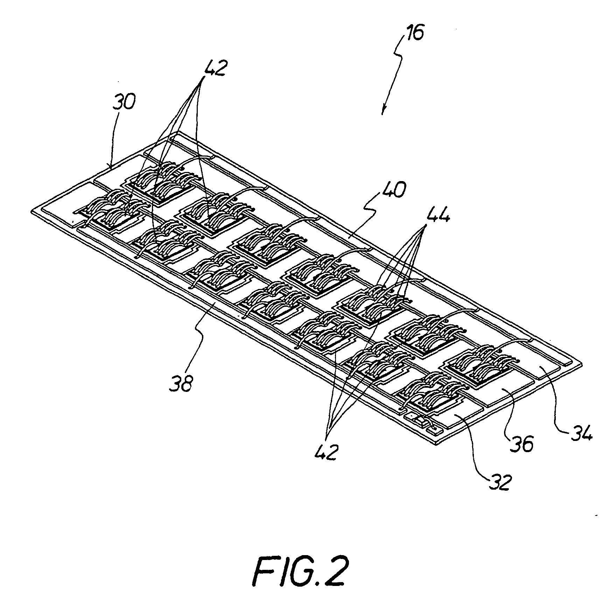

Figur 1 zeigt wesentliche Teile einer Ausbildung der Schaltungsanordnung 10 mit einem Grundkörper 12. Der rahmenartige Grundkörper 12 ist an einem Kühlkörper angebracht, er weist drei voneinander getrennte Abteile 14 auf. Jedes Abteil 14 ist für ein Substrat 16 vorgesehen. Ein solches Substrat 16 ist in Figur 2 dargestellt und wird weiter unten ausführlicher beschrieben.

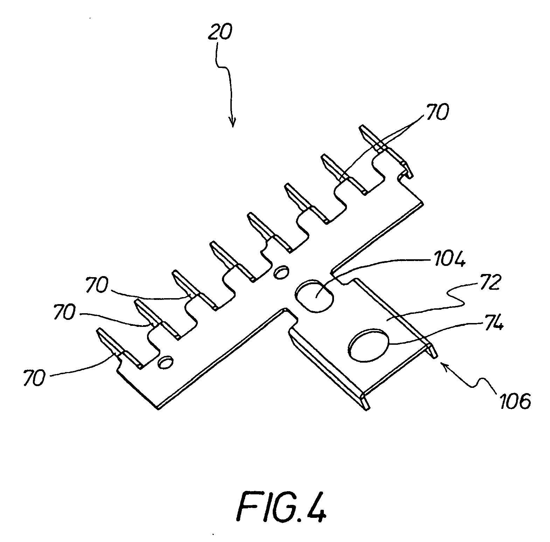

Vom Grundkörper 12 stehen Zapfen 18 nach oben, die zur exakten Positionierung eines jeweils zugehörigen Wechselstromanschlusselementes 20 vorgesehen sind. Ein solches Wechselstromanschlusselement 20 ist in Figur 4 dargestellt und wird weiter unten ausführlicher beschrieben.

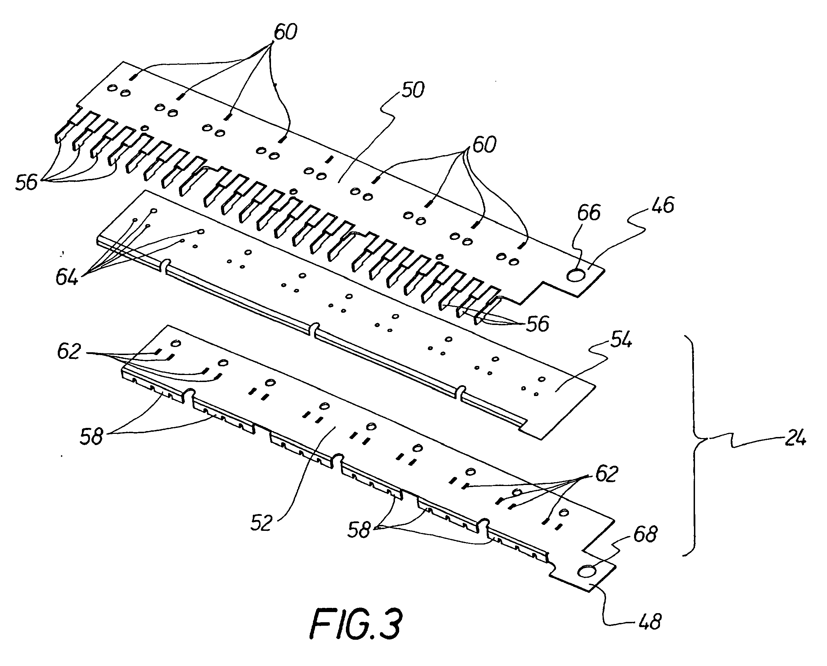

Vom Grundkörper 12 stehen außerdem zwei Zapfen 22 nach oben, die zur genauen Positionierung einer Zwischenkreisplatine 24 vorgesehen sind. Eine solche Zwischenkreisplatine 24 ist in Figur 3 perspektivisch in einer Explosionsdarstellung - ohne die zugehörigen elektrischen Kondensatoren - dargestellt und wird weiter unten ausführlicher beschrieben.

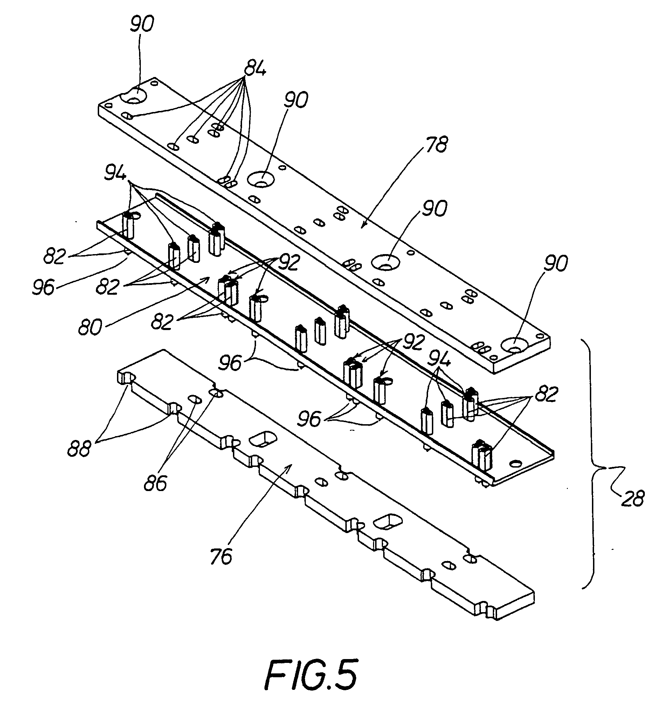

Vom Grundkörper 12 stehen Gewindehülsen 26 einstückig nach oben, die zur Festlegung der in Figur 5 perspektivisch in einer Explosionsdarstellung gezeichneten Druckeinrichtung 28 am Grundkörper 12 dienen.

Das/jedes Substrat 16 weist an seiner Oberseite 30 eine Pluspol-Leiterbahn 32, eine Minuspol-Leiterbahn 34, eine zwischen diesen vorgesehene Wechselstrom-Leiterbahn 36 sowie Hilfsanschlussbahnen 38 und 40 auf. Bauelemente 42, wie z.B. Leistungstransistoren oder Leistungsdioden, sind mit den Leiterbahnen 32, 34, 36 und mit den Hilfsanschlussbahnen 38 und 40 kontaktiert. Diese Kontaktierung erfolgt beispielsweise mittels Bonddrähten 44.

Mit der Pluspol-Leiterbahn 34 des jeweiligen Substrates 16 ist ein Pluspol-Gleichstromanschluss 46 der Zwischenkreisplatine 24 kontaktiert. Mit der Minuspol-Leiterbahn 34 des jeweiligen Substrates 16 ist ein Minuspol-Gleichstromanschluss 48 der Zwischenkreisplatine 24 (sh. auch Figur 3) kontaktiert. Zu diesem Zwecke weist die Zwischenkreisplatine 24 ein den Pluspol-Gleichstromanschluss 46 aufweisendes erstes Metallflächenelement 50 und ein den Minuspol-Gleichstromanschluss 48 aufweisendes zweites Metallflächenelement 52 auf, zwischen welchen ein flächenmäßig an die Metallflächenelemente 50 und 52 angepasstes Isolierelement 54 vorgesehen ist, wie aus Figur 3 ersichtlich ist.

Bei dem Metallflächenelement 50 und bei dem Metallflächenelement 52 handelt es sich jeweils um ein Stanzblech aus elektrisch leitendem Metall wie Kupfer, wobei vom Metallflächenelement 50 für den Pluspol-Gleichstromanschluss 46 Kontaktelemente 56 einstückig wegstehen. Die Kontaktelemente 56 sind in Querrichtung des länglichen Metallflächenelementes 50 orientiert und schließen mit dem Metallflächenelement 50 einen rechten Winkel ein. Die Kontaktflächenelemente 56 werden mit Hilfe der Druckeinrichtung 28 gegen die Pluspol-Leiterbahn 32 des jeweiligen Substrates 16 gedrückt.

Vom Metallflächenelement 52 des Minuspol-Gleichstromanschlusses 48 stehen in Längsrichtung orientiert senkrecht Kontaktelemente 58 weg, die mit Hilfe der Druckeinrichtung 28 gegen die Minuspol-Leiterbahn 34 des jeweiligen Substrates 16 gedrückt werden.

Das Metallflächenelement 50 des Pluspol-Gleichstromanschlusses 46 ist mit Kontaktlöchern 60 zur elektrisch leitenden Kontaktierung der entsprechenden Anschlusselemente nicht gezeichneter Kondensatoren der Zwischenkreisplatine 24 ausgebildet. Das Metallflächenelement 52 des Minuspol-Gleichstromanschlusses 48 ist mit Kontaktlöchern 62 für die Minuspol-Anschlusselemente der nicht gezeichneten Kondensatoren der Zwischenkreisplatine 24 versehen. Das Isolierelement 54 ist mit daran angepaßten Durchgangslöchern 64 für die Anschlusselemente der Kondensatoren der Zwischenkreisplatine 24 ausgebildet.

Durch die eng benachbarte Anordnung der Zwischenkreisplatine 24, gebildet aus den Metallflächenelementen 50, 52 mit direkt daran angeordneten Kontaktelementen 56, 58 und dem Isolierelement 54, sowie den direkt auf dem Kühlkörper befindlichen Substraten 16 ergibt sich ein sehr effizienter thermischer Kontakt zwischen den auf der Zwischenkreisplatine 24 angeordneten Kondensatoren und dem Kühlkörper. Dies erlaubt eine wirksame Abfuhr der im Zwischenkreis entstehenden Wärme.

Der Pluspol-Gleichstromanschluss 46 ist mit einem Loch 66 ausgebildet, durch das sich der eine vom Grundkörper 12 nach oben stehende Zapfen 22 erstreckt. Der Minuspol-Gleichstromanschluss 48 ist mit einem Loch 68 ausgebildet, durch den sich der andere Zapfen 22 des Grundkörpers erstreckt.

Figur 4 verdeutlicht perspektivisch ein Wechselstromanschlusselement 20, das als Stanzblechteil mit Kontaktelementen 70 - ähnlich den Kontaktelementen 56 des Metallflächenelementes 50 - für den Pluspol-Gleichstromanschluss 46 und das mit einer Anschlusslasche 72 ausgebildet ist. Die Anschlusslasche 72 des jeweiligen Wechselstromanschlusselementes 20 ist mit einem Loch 74 ausgebildet, durch das sich der entsprechende Zapfen 18 des Grundkörpers 12 im zusammengebauten Zustand erstreckt. In der Anschlusslasche 72 befindet sich noch ein weiteres Loch 104 zur Aufnahme eines Stromsensor 114 (sh. auch Fig. 1). Die Kontaktelemente 70 des jeweiligen Wechselstromanschlusselementes 20 sind mit der Wechselstrom-Leiterbahn 36 des jeweiligen Substrates 16 kontaktiert. Die Kontaktelemente 56 und 58 der Metallflächenelemente 50 und 52 für den Pluspol-Gleichstromanschluss 46 und für den Minuspol-Gleichstromanschluss 48 der Zwischenkreisplatine 24 dienen zur direkten niederinduktiven Kontaktierung mit den zugehörigen Leiterbahnen 32 und 34 des jeweiligen Substrates 16 der Schaltungsanordnung 10.

Der Bereich der Anschlusslasche 72 um das Loch 104 für den Stromsensor 114 bedarf einer effizienten Wärmeabführung, da einerseits eine zu hohe Temperatur die Funktion des Stromsensor beeinträchtigt, sowie andrerseits eine zu hohe Temperatur der Anschlusslasche 72 den Ohmschen Widerstand derselben erhöht und den maximalen Stromdurchfluss und somit direkt die Leistungsfähigkeit der Schaltungsanordnung reduziert.

Figur 5 verdeutlicht in einer perspektivischen Explosionsdarstellung eine Ausbildung der Druckeinrichtung 28 der Schaltungsanordnung 10 (sh. Figur 1). Die Druckeinrichtung 28 weist ein begrenzt nachgiebiges Druckelement 76 und einen formstabilen Druckkörper 78 auf. Zwischen dem begrenzt nachgiebigen Druckelement 76 und dem daran grundflächenmäßig angepaßten formstabilen Druckkörper 78 ist ein Zwischenkörper 80 aus elektrisch isolierendem Material vorgesehen, von dem Isolierhülsen 82 wegstehen. Die Isolierhülsen 82 erstrecken sich im zusammengebauten Zustand der Druckeinrichtung 28 durch entsprechende Löcher 84 des formstabilen Druckkörpers 78 sowie in Löcher 86 und Aussparungen 88 des Druckelementes 76. Der formstabile Druckkörper 78 besteht beispielsweise aus Metall, er ist mit Senklöchem 90 beispielsweise für Senkkopfschrauben ausgebildet. Die Senklöcher 90 sind mit den vom Grundkörper 12 wegstehenden Gewindehülsen 26 deckungsgleich vorgesehen, um mit Hilfe der genannten Senkkopfschrauben die Druckeinrichtung 28 am Grundkörper 12 zu fixieren, wobei gleichzeitig mit Hilfe der Druckeinrichtung 28 die Zwischenkreisplatine 24 mit den Substraten 16 passend kontaktiert wird.

Durch die Isolierhülsen 82 des Zwischenkörpers 80 der Druckeinrichtung 28 erstrecken sich Kontaktdrahtelemente 92, die oberseitig mit einem Kontaktabschnitt 94 aus den Isolierhülsen 82 geringfügig und die mit unterseitigen stiftförmigen Endabschnitten 96 unterseitig aus den Isolierhülsen 82 vorstehen. Im zusammengebauten Zustand der Schaltungsanordnung 10 werden die oberseitigen Kontaktabschnitte 94 der Kontaktdrahtelemente 92 mit zugehörigen Kontaktstellen einer auf der Druckeinrichtung 28 positionierten (nicht dargestellten) Treiberschaltung kontaktiert. Die unterseitigen stiftförmigen Endabschnitte 96 der Kontaktdrahtelemente 92 werden dabei mit den zugehörigen Leiterbahnen und Hilfsanschlussbahnen des jeweiligen Substrates 16 kontaktiert.

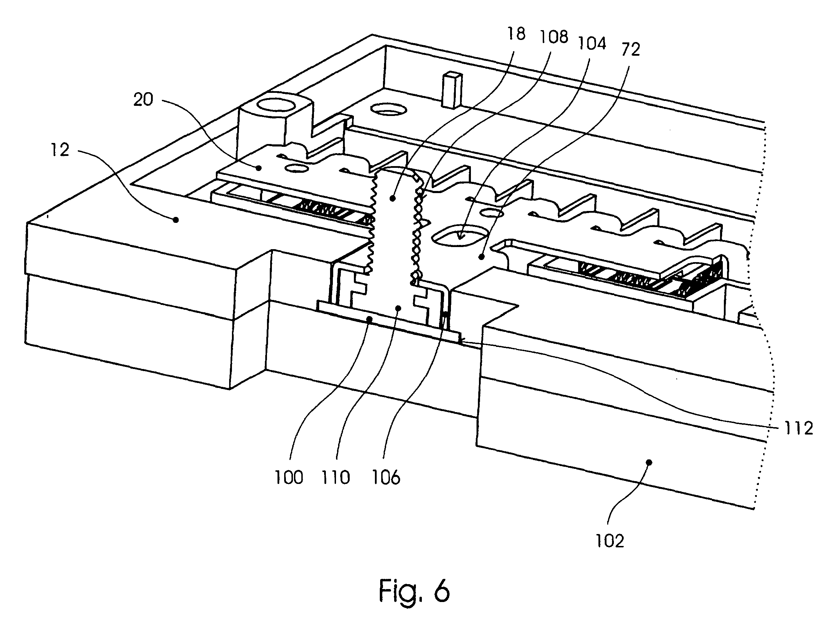

Fig. 6 zeigt Details zur Verbesserung der Wärmeabführung aus dem Bereich der Anschlusslasche 72. Dazu sind im Bereich der Anschlusslaschen Ausnehmungen 112 in dem Grundkörper 12 ausgebildet. Diese Ausnehmungen sind derart gestaltet, um darin einen elektrisch isolierenden Körper 100 (z.B. Glimmer oder Aluminiumoxid) mit geringem thermischen Widerstand aufzunehmen. Die Wärmeabführung wird nun auf zwei Wegen erreicht, die vorteilhafterweise beide eingesetzt werden, obwohl jeder für sich bereits eine Reduzierung der Temperatur der Anschlusslasche 72 erzielt:
- Auf zwei gegenüberliegenden Seiten der Anschlusslasche 72 werden Bereiche 106 derart abgewinkelt, daß sie nach dem Zusammenbau in direktem thermischen Kontakt mit dem Körper 100 stehen. Dieser wiederum steht in direktem thermischen Kontakt mit dem Kühlkörper 102.
- Der Zapfen 18 ist derart ausgebildet, dass er aus einem Anschlussbereich, vorteilhafterweise mit einem Gewinde 108, und aus einem Fuß 110 besteht, wobei der Fuß direkten thermischen Kontakt zum elektrisch isolierenden Körper 100 aufweist, der seinerseits direkten thermischen Kontakt mit dem Kühlkörper 102 aufweist.

Der Anschlusszapfen 18 sowie die Anschlusslasche 72 sind elektrisch leitend verbunden um einen externen Wechselstromanschluss zu ermöglichen.

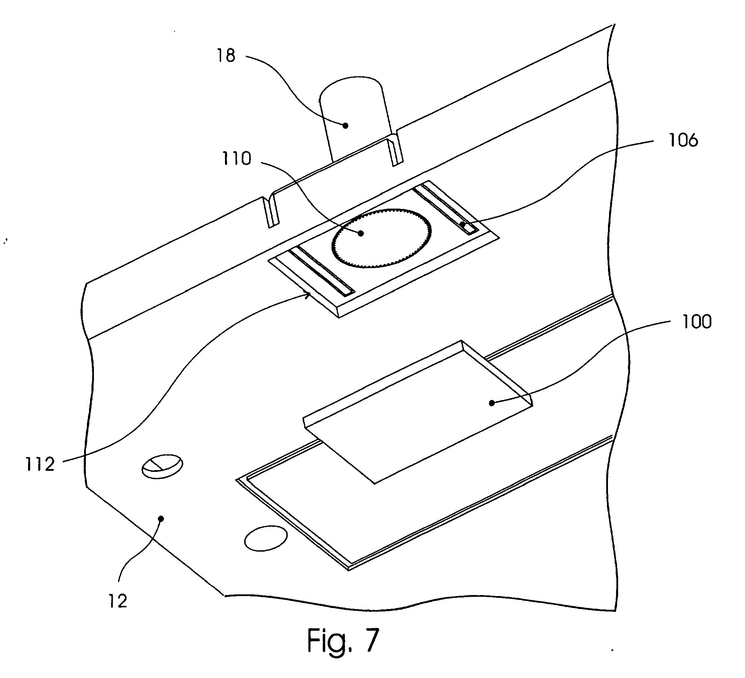

Fig. 7 zeigt eine Explosionszeichnung eines Wechselstromanschlusses aus Blickrichtung des Kühlkörpers, der hier nicht gezeichnet ist. Die Ausnehmung 112 ist derart gestaltet, daß ein thermisch leitender und elektrisch isolierender Körper 100 den thermischen Kontakt zwischen dem Fuß 110 des Anschlusszapfens 18 und den abgewinkelten Teilbereichen 106 (sh. auch Fig. 4) der Anschlusslasche 72 einerseits und dem Kühlkörper 102 andererseits bildet.

### Bezugsziffernliste:

- 10: Schaltungsanordnung
- 12: Grundkörper (von 10)
- 14: Abteile (von 12)
- 16: Substrat (in 14)
- 18: Zapfen (an 12 für 20)
- 20: Wechselstromanschlusselement (von 10)
- 22: Zapfen (an 12 für 46, 48)
- 24: Zwischenkreisplatine (von 10)
- 26: Gewindehülsen (an 12 für 28)
- 28: Druckeinrichtung (von 10)
- 30: Oberseite (von 16)
- 32: Pluspol-Leiterbahn (an 30)
- 34: Minuspol-Leiterbahn (an 30)
- 36: Wechselstrom-Leiterbahn (an 30)
- 38: Hilfsanschlussbahnen (an 30)
- 40: Hilfsanschlussbahnen (an 30)
- 42: Bauelemente (an 16)
- 44: Bonddrähte (an 42)
- 46: Pluspol-Gleichstromanschluss (von 24)
- 48: Minuspol-Gleichstromanschluss (von 24)
- 50: Metallflächenelement (von 46)
- 52: Metallflächenelement (von 48)
- 54: Isolierelement (von 24 zwischen 50 und 52)
- 56: Kontaktelemente (an 50)
- 58: Kontaktelemente (an 52)
- 60: Kontaktlöcher (in 50)
- 62: Kontaktlöcher (in 52)
- 64: Durchgangslöcher (in 54)
- 66: Loch (in 46)
- 68: Loch (in 48)
- 70: Kontaktelemente (von 20)
- 72: Anschlusslasche (von 20)
- 74: Loch (in 72)
- 76: begrenzt nachgiebiges Druckelement (von 28)
- 78: formstabiler Druckkörper (von 28)
- 80: Zwischenkörper (von 28 zwischen 76 und 78)
- 82: Isolierhülsen (von 80)
- 84: Löcher (in 78)
- 86: Löcher (in 76)
- 88: Aussparungen (in 76)
- 90: Senklöcher (in 78)
- 92: Kontaktdrahtelemente (in 82)
- 94: Kontaktabschnitt (von 92)
- 96: stiftförmiger Endabschnitt (von 92)
- 100: Isolierkörper
- 102: Kühlkörper
- 104: Loch (in 72)
- 106: Teilbereich (der Anschlusslasche 72)
- 108: Gewinde (des Anschlusszapfen 18)
- 110: Fuß (des Anschlusszapfen 18)
- 112: Ausnehmung (aus 12)
- 114: Stromsensor

## Patentansprüche

1. Schaltungsanordnung mit einem Grundkörper (12), mit mindestens einem hierauf angeordneten Substrat (16), das an seiner Oberseite (30) eine Pluspol-Leiterbahn (32), eine Minuspol-Leiterbahn (34) und eine Wechselstrom-Leiterbahn (36) sowie Hilfsanschlussbahnen (38, 40) aufweist, mit Bauelementen (42), die zumindest teilweise mit den Leiterbahnen (32, 34, 36) und mit den Hilfsanschlussbahnen (38, 40) kontaktiert sind, mit einer Zwischenkreisplatine (24) mit einem nach außen reichenden Pluspol-Gleichstromanschluss (46) und einem nach außen reichenden Minuspol-Gleichstromanschluss (48) und mit mindestens einem zwischen dem Pluspol-Gleichstromanschluss (46) und dem Minuspol-Gleichstromanschluss (48) eingeschalteten elektrischen Kondensator, und mit mindestens einem nach außen reichenden Wechselstromanschlusselement (20), wobei
die Zwischenkreisplatine (24) als eine Mehrzahl von Kontaktfingern ausgeführte Kontaktelemente (56, 58) zur direkten niederinduktiven Kontaktierung mit den zugehörigen Leiterbahnen (32, 34) aufweist, und der Zwischenkreisplatine (24) und dem mindestens einen Substrat (16) ein zugehöriges Wechselstromanschlusselement (20) mit jeweils einer Mehrzahl von Kontaktfingern als Kontaktelementen (70) zur Kontaktierung der zugehörigen Leiterbahnen (36)zugeordnet ist **gekennzeichnet durch** mindestens einen Anschlußzapfen (18, 22), der in den Grundkörper (12) eingebettet ist und einer zugeordneten Anschlußlasche (46, 48, 72) thermisch und elektrisch leitend verbunden ist, wobei mindestens der Anschlusszapfen (18,22) einen Fuß (110) aufweist, der über einen elektrisch isolierenden und thermisch leitenden Körper (100) auf einem Kühlkörper (102) angeordnet ist und / oder mindestens eine Anschlusslasche (46, 48, 72) Teilbereiche (106) aufweist, die über einen elektrisch isolierenden Körper (100) einen thermischen Kontakt zu dem Kühlkörper (102) aufweisen und wobei die Zwischenkreisplatine (24) ein den Pluspol-Gleichstromanschluss (46) aufweisendes erstes Metallflächenelement (50) und ein den Minuspol-Gleichstromanschluss (48) aufweisendes zweites Metallflächenelement (52) aufweist, die voneinander elektrisch isoliert sind und die Kontaktelemente (56, 58) der Zwischenkreisplatine (24) mit dem jeweils zugehörigen Metallflächenelement (50, 52) einstückig ausgebildet sind und mit mindestens einem Wechselstromanschlußelement (20) mit Kontaktelementen (70) mit Anschlußlaschen (72), wobei das Substrat (16), die Kontaktelemente (56, 58) und die Metallflächenelemente (50, 52) eng benachbart angeordnet sind und eine kurze thermisch leitende und elektrisch isolierende Verbindung zwischen der Zwischenkreisplatine (24) und dem Kühlköper bilden.

2. Schaltungsanordnung nach Anspruch 1,
**dadurch gekennzeichnet ,**
**dass** drei Substrate (16) für die drei Drehstrom-Phasen (U, V, W) vorgesehen sind.

3. Schaltungsanordnung nach Anspruch 1,
**dadurch gekennzeichnet ,**
**dass** der Grundkörper (12) an einem Kühlkörper angebracht ist, und daß das mindestens eine Substrat (16) mit seiner Unterseite mit dem Grundkörper (12) thermisch leitend kontaktiert ist..

4. Schaltungsanordnung nach Anspruch 1,
**dadurch gekennzeichnet,**
**dass** das mindestens eine Wechselstromanschlusselement (20) mit den zugehörigen Kontaktelementen (70) einstückig ausgebildet ist.

5. Schaltungsanordnung nach Anspruch 1,
**dadurch gekennzeichnet,**
**dass** die Bauelemente (42) Leistungsdioden, Leistungsthyristoren, Leistungstransistoren, Sensoren, Widerstände und / oder integrierte Schaltungen sind.

6. Schaltungsanordnung nach Anspruch 1,
**dadurch gekennzeichnet,**
**dass** eine Druckeinrichtung (28) zur elektrischen Kontaktierung der Kontaktelemente (56, 58, 70) mit den Leiterbahnen (32, 34, 36) des mindestens einen Substrates (16) vorgesehen ist.

7. Schaltungsanordnung nach Anspruch 8,
**dadurch gekennzeichnet,**
**dass** die Druckeinrichtung (28) einen formstabilen Druckkörper (78) und ein begrenzt nachgiebiges Druckelement (76) mit an den Druckkörper (78) angepaßten Flächenabmessungen aufweist.

8. Schaltungsanordnung nach Anspruch 2,
**dadurch gekennzeichnet,**
**dass** der thermisch leitenden und elektrisch isolierende Körper (100) aus einem keramischen Werkstoff besteht.

9. Schaltungsanordnung nach Anspruch 2,
**dadurch gekennzeichnet ,**
**dass** der Anschlußzapfen (18) an seinem von seinem Fuß (110) abgewandten Teil ein Gewinde (108) aufweist.

10. Schaltungsanordnung nach Anspruch 2,
**dadurch gekennzeichnet ,**
**dass** die Teilbereiche (106) der Anschlußlasche (72) durch abgewinkelte Bereiche der Anschlußlasche selbst gebildet werden.

## Claims

1. A circuit arrangement with a base body (12), with at least one substrate (16) arranged on the latter, which substrate on its upper face (30) has a plus-pole conducting track (32), a minus-pole conducting track (34) and an alternating current conducting track (36), and also ancillary connecting tracks (38, 40), with components (42) that at least partly make contact with the conducting tracks (32, 34, 36) and with the ancillary connecting tracks (38, 40), with an intermediate circuit board (24) with an outwardly extending plus-pole direct current connection (46) and an outwardly extending minus-pole direct current connection (48) and with at least one electrical capacitor connected between the plus-pole direct current connection (46) and the minus-pole direct current connection (48), and with at least one outwardly extending alternating current connecting element (20), wherein
the intermediate circuit board (24) has contact elements (56, 58), embodied as a multiplicity of contact fingers, for purposes of making direct low inductance contact with the corresponding conducting tracks (32, 34), and a corresponding alternating current connecting element (20), in each case with a multiplicity of contact fingers (70), is assigned to the intermediate circuit board (24) and to the at least one substrate (16), for purposes of making contact with the corresponding conducting tracks (36),
**characterised by** at least one connecting peg (18, 22), which is embedded in the base body (12), and is connected to an assigned connecting tab (46, 48, 72) in a thermally and electrically conducting manner, wherein
the at least one connecting peg (18, 22) has a foot (110), which is arranged on a cooling body (102) above an electrically insulating and thermally conducting body (100), and/or at least one connecting tab (46, 48, 72) has sub-regions (106), which make thermal contact with the cooling body (102) via an electrically insulating body (100), and wherein
the intermediate circuit board (24) has a first metal surface element (50) having the plus-pole direct current connection (46) and a second metal surface element (52) having the minus-pole direct current connection (48), which are electrically insulated from one another, and the contact elements (56, 58) of the intermediate circuit board (24) are integrally designed in each case with the corresponding metal surface element (50, 52), and with at least one alternating current connecting element (20) with contact elements (70) with connecting tabs (72), wherein
the substrate (16), the contact elements (56, 58), and the metal surface elements (50, 52) are arranged closely adjacent and form a short thermally conducting and electrically insulating connection between the intermediate circuit board (24) and the cooling body.

2. The circuit arrangement according to Claim 1,
**characterised in that** three substrates (16) are provided for the three alternating current phases (U, V, W).

3. The circuit arrangement according to Claim 1,
**characterised in that** the base body (12) is attached to a cooling body, and **in that** the at least one substrate (16) with its lower face makes thermally conducting contact with the base body (12).

4. The circuit arrangement according to Claim 1,
**characterised in that** the at least one alternating current connecting element (20) is integrally designed with the corresponding contact elements (70).

5. The circuit arrangement according to Claim 1,
**characterised in that** the components (42) are power diodes, power thyristors, power transistors, sensors, resistances, and/or integrated circuits.

6. The circuit arrangement according to Claim 1,
**characterised in that** a pressure device (28) is provided for purposes of making electrical contact between the contact elements (56, 58, 70) and the conducting tracks (32, 34, 36) of the at least one substrate (16).

7. The circuit arrangement according to Claim 8,
**characterised in that** the pressure device (28) has a dimensionally stable pressure body (78) and a pressure element (76) of limited flexibility with surface area dimensions aligned with the pressure body (78).

8. The circuit arrangement according to Claim 2,
**characterised in that** the thermally conducting and electrically insulating body (100) consists of a ceramic material.

9. The circuit arrangement according to Claim 2,
**characterised in that** the connecting peg (18) has a thread (108) on its part facing away from its foot (110).

10. The circuit arrangement according to Claim 2,
**characterised in that** the sub-regions (106) of the connecting tab (72) are formed from bent regions of the connecting tab itself.

## Revendications

1. Agencement de circuit comprenant un corps de base (12), au moins un substrat (16) disposé dessus, qui présente sur son côté supérieur (30) une piste conductrice à pôle plus (32), une piste conductrice (34) à pôle moins et une piste conductrice à courant alternatif (36) ainsi que des pistes de raccordement auxiliaires (38, 40), des composants (42), qui sont en contact au moins en partie avec les pistes conductrices (32, 34, 36) et avec les pistes de raccordement auxiliaires (38, 40), une platine de circuit intermédiaire (24) avec un raccordement de courant continu à pôle plus (46) allant vers l'extérieur et un raccordement de courant continu à pôle moins (48) allant vers l'extérieur et au moins un condensateur électrique enclenché entre le branchement de courant continu à pôle plus (46) et le branchement de courant continu à pôle moins (48), et au moins un élément de raccordement de courant alternatif (20) allant vers l'extérieur, la platine de circuit intermédiaire (24) présentant des éléments de contact (56, 58) réalisés sous la forme d'une pluralité de doigts de contact pour la mise en contact directe et faiblement inductive avec les pistes conductrices (32, 34) spécifiques, et un élément de raccordement à courant alternatif (20) spécifique avec à chaque fois une pluralité de doigts de contact sous forme d'éléments de contact (70) pour la mise en contact des pistes conductrices (36) spécifiques étant attribué à la platine de circuit intermédiaire (24) et au au moins un substrat (16),
**caractérisé par** au moins un tenon de raccordement (18, 22) qui est enfoncé dans le corps de base (12) et est relié thermiquement et de façon électroconductrice à une patte de raccordement (46, 48, 72) associée, au moins le tenon de raccordement (18, 22) présentant une base (110) qui est disposée au moyen d'un corps (100) électro-isolant et thermoconducteur sur un corps de refroidissement (102) et/ou au moins une patte de raccordement (46, 48, 72) présentant des zones partielles (106) qui présentent au moyen d'un corps (100) électro-isolant un contact thermique avec le corps de refroidissement (102) et la platine de circuit intermédiaire (24) présentant un premier élément de surface métallique (50) présentant le raccordement de courant continu à pôle plus (46) et un second élément de surface métallique (52) présentant le raccordement de courant continu à pôle moins (48), lesquels éléments sont isolés électriquement l'un de l'autre et lesquels éléments de contact (56, 58) de la platine de circuit intermédiaire (24) sont conçus d'une seule pièce avec l'élément de surface métallique (50, 52) respectivement associé et avec au moins un élément de raccordement de courant alternatif (20) avec des éléments de contact (70) dotés de pattes de raccordement (72), le substrat (16), les éléments de contact (56, 58) et les éléments de surface métallique (50, 52) étant disposés à proximité les uns des autres et formant une liaison courte, thermoconductrice et électro-isolante entre la platine de circuit intermédiaire (24) et le corps de refroidissement.

2. Agencement de circuit selon la revendication 1,
**caractérisé en ce que**
trois substrats (16) sont prévus pour les trois phases de courant triphasé (U, V, W).

3. Agencement de circuit selon la revendication 1,
**caractérisé en ce que**
le corps de base (12) est placé sur un corps de refroidissement et **en ce que** le au moins un substrat (16) est mis en contact de façon thermoconductrice par son côté inférieur avec le corps de base (12).

4. Agencement de circuit selon la revendication 1,
**caractérisé en ce que**
le au moins un élément de raccordement de courant alternatif (20) est conçu d'une seule pièce avec les éléments de contact (70) spécifiques.

5. Agencement de circuit selon la revendication 1,
**caractérisé en ce que**
les composants (42) sont des diodes de puissance, des thyristors de puissance, des transistors de puissance, des capteurs, des résistances et/ou des circuits intégrés.

6. Agencement de circuit selon la revendication 1,
**caractérisé en ce**
**qu'**un dispositif de pression (28) est prévu pour la mise en contact électrique des éléments de contact (56, 58, 70) avec les pistes conductrices (32, 34, 36) du au moins un substrat (16).

7. Agencement de circuit selon la revendication 8,
**caractérisé en ce que**
le dispositif de pression (28) forme un corps de pression (78) indéformable et présente un élément de pression (76) flexible de façon limitée avec des dimensions de surface adaptées au corps de pression (78).

8. Agencement de circuit selon la revendication 2,
**caractérisé en ce que**
le corps (100) thermoconducteur et électro-isolant est à base d'un matériau céramique.

9. Agencement de circuit selon la revendication 2,
**caractérisé en ce que**
le tenon de raccordement (18) présente un filetage (108) sur sa partie opposée à son pied (110).

10. Agencement de circuit selon la revendication 2,
**caractérisé en ce que**
les zones partielles (106) de la patte de raccordement (72) sont formées par des zones coudées de la patte de raccordement même.
